# FASCICULE DE BREVET EUROPEEN

(11) **EP 3 855 623 B1**
(45) Date de publication et mention de la délivrance du brevet: **17.06.2026**
(21) Numéro de dépôt: 21150855.1
(22) Date de dépôt: 11.01.2021
(51) Int. Cl.: H03K 9/02, H03K 19/0175

(54) **CIRCUIT INTÉGRÉ DE CONDITIONNEMENT**
INTEGRIERTER SCHALTKREIS FÜR KLIMAANLAGEN
INTEGRATED PACKAGING CIRCUIT

(30) Priorité: 24.01.2020 FR 2000712
(43) Date de publication de la demande: 28.07.2021
(73) Titulaire: STMicroelectronics (Rousset) SAS, 13790 Rousset (FR)
(72) Inventeur: FROIDEVAUX, Nicolas, 13100 AIX EN PROVENCE (FR); LOPEZ, Laurent, 13790 PEYNIER (FR)
(74) Mandataire: Casalonga

(56) Documents cités:
- US-A- 2 551 529
- US-A- 3 133 205
- US-B1- 6 420 873

## Description

Des modes de mise en œuvre et de réalisation de l'invention concernent les circuits intégrés, en particulier ceux affectés à un conditionnement d'un signal analogique oscillant comprenant une succession d'oscillations amorties.

On connait des circuits intégrés comportant des unités de traitement configurées pour traiter des signaux analogiques oscillants comprenant une succession d'oscillations présentant une amplitude décroissante dans le temps.

Par exemple, on connait des débitmètres comprenant une unité de traitement configurée pour déterminer un débit de fluide à partir de signaux analogiques oscillants générés par des capteurs inductifs-capacitifs, désignés également par le terme « capteurs LC », utilisés en combinaison d'une roue placée dans un écoulement de fluide et présentant au moins une portion conductrice.

Les capteurs LC comprennent notamment une capacité et une inductance connectées en parallèle, et sont connectés à des cellules d'entrées/sorties reliés à l'unité de traitement.

Ces capteurs LC génèrent des signaux analogiques oscillants comprenant une succession d'oscillations amorties. Ces signaux analogiques oscillants sont transmis à l'unité de traitement par l'intermédiaire des cellules d'entrées/sorties du circuit intégré. L'unité de traitement est alors configurée pour déterminer un débit du fluide à partir des signaux analogiques oscillants générés par les capteurs LC.

Néanmoins, ces signaux analogiques oscillants peuvent présenter l'inconvénient de comprendre des premières oscillations de fortes amplitudes pouvant entraîner une défaillance des composants électroniques de l'unité de traitement.

Afin de remédier à cet inconvénient, des solutions connues consistent à limiter la tension alimentant le capteur LC pour compenser la surtension résultant des premières oscillations. Cette limitation impose une contrainte supplémentaire dans la conception du débitmètre et limite la flexibilité d'avoir des fonctionnalités alternatives pour les cellules d'entrée/sortie avec des plages de puissance d'alimentation différentes.

Une autre solution consiste à utiliser des diodes de protection contre les décharges électrostatiques (en anglais *« electrostatic discharge diodes* », plus connu sous l'acronyme « *ESD diodes »*). Une telle solution est néanmoins coûteuse.

US 6 420 873 B1 présent de manière générale les équipements d'imagerie par résonance magnétique, et plus particulièrement un procédé de réduction du bruit transitoire qui interfère avec le signal souhaité et peut diminuer la qualité de l'image produite.

US 2 551 529 A concerne un dispositif électronique destiné à l'analyse de la distribution des impulsions électriques, et plus particulièrement un sélecteur ou discriminateur différentiel d'amplitude d'impulsions, conçu pour déterminer combien d'impulsions, éventuellement de valeur aléatoire, se produisent dans une plage d'amplitude prédéterminée.

US 3 133 205 A divulgue un circuit transistorisé qui délivre une impulsion de sortie uniquement lorsque l'amplitude d'une impulsion d'entrée se situe entre deux limites définies. Ce type de circuit est couramment utilisé dans les systèmes de suivi d'amplitude d'impulsions ainsi que dans les équipements de test en tant qu'analyseur de hauteur d'impulsions.

Il existe donc un besoin de pouvoir proposer une solution permettant de réduire voire d'éliminer le risque de défaillance des composants électroniques d'une unité de traitement, provenant de signaux analogiques oscillants comprenant des premières oscillations de forte amplitude.

Plus particulièrement, il existe un besoin de pouvoir proposer une telle solution ne présentant pas les inconvénients des solutions connues susmentionnées.

Selon un aspect, il est proposé un circuit intégré de conditionnement d'un signal analogique oscillant comprenant une succession d'oscillations amorties, le circuit intégré comprenant une cellule d'entrée/sortie comportant :
- un premier port configuré pour recevoir ledit signal analogique oscillant, dit signal d'entrée,
- un deuxième port configuré pour délivrer un signal analogique de sortie à partir du signal d'entrée,
- des moyens de contrôle couplés entre le premier port et le deuxième port et configurés pour supprimer du signal d'entrée au moins la première oscillation de façon à délivrer dans le signal de sortie des oscillations du signal d'entrée ayant une amplitude inférieure à un premier seuil, par exemple 5V.

La sortie du circuit intégré peut notamment être reliée à une unité de traitement de façon à pouvoir transmettre à cette dernière le signal analogique oscillant délivré par le deuxième port.

Le premier seuil est alors avantageusement compatible avec un fonctionnement correct de l'unité de traitement connectée au deuxième port, c'est-à-dire compatible avec un niveau maximum de tension tolérable par l'unité de traitement.

Un tel circuit intégré permet de ne pas transmettre les oscillations présentant une amplitude, typiquement un niveau de tension crête à crête, supérieure audit seuil, à l'unité de traitement. Ces oscillations pourraient en effet entraîner une défaillance de l'unité de traitement si elles étaient transmises à cette dernière. Ainsi, un tel circuit intégré permet de réduire voire d'éliminer le risque de défaillance de l'unité de traitement.

De préférence, le circuit intégré comprend en outre ladite unité de traitement connectée au deuxième port, le premier seuil étant compatible avec un niveau maximum de tension tolérable par l'unité de traitement.

Avantageusement, le circuit intégré comprend en outre une unité principale de contrôle. Par ailleurs, les moyens de contrôle comportent un interrupteur connecté entre le premier port et le deuxième port, l'interrupteur étant commandable par l'unité principale de contrôle. Les moyens de contrôle comprennent en outre une unité auxiliaire de contrôle configurée pour prendre temporairement le contrôle de l'interrupteur à la place de l'unité principale de contrôle de façon à permettre ladite suppression de ladite au moins la première oscillation du signal d'entrée.

L'interrupteur permet de communiquer le signal d'entrée à l'unité de traitement. L'unité principale de contrôle est configurée pour contrôler habituellement l'interrupteur par un signal de commande. Néanmoins, l'unité auxiliaire de contrôle est configurée pour prendre le contrôle de l'interrupteur temporairement de façon à supprimer ladite au moins la première oscillation du signal d'entrée, quel que soit le signal de commande de l'unité principal de contrôle.

La cellule d'entrée/sortie IO comprenant les moyens de contrôle peut alors être conçue à partir d'une cellule d'entrée/sortie classique dans laquelle l'unité auxiliaire de contrôle est ajoutée.

De préférence, l'interrupteur est configuré pour fonctionner en présence d'une ou de plusieurs oscillations du signal d'entrée ayant une amplitude supérieure ou égale audit premier seuil, et ayant une première borne reliée au premier port et une seconde borne reliée au deuxième port, l'interrupteur pouvant être commandé :
∘ soit dans un état fermé connectant électriquement le premier port au deuxième port,
∘ soit dans un état ouvert déconnectant le premier port du deuxième port.

En outre, l'unité auxiliaire de contrôle est configurée pour :
∘ maintenir l'interrupteur dans un état ouvert pendant la première oscillation du signal d'entrée et éventuellement une ou plusieurs oscillations succédant directement à la première oscillation, puis
∘ permettre un basculement de l'interrupteur vers un état fermé.

En particulier, l'unité auxiliaire de contrôle force l'interrupteur dans un état ouvert pendant la ou les premières oscillations du signal d'entrée. L'unité auxiliaire de contrôle permet ainsi d'empêcher la transmission de ces oscillations au deuxième port du circuit intégré. En outre, l'unité auxiliaire de contrôle en permettant un basculement de l'interrupteur vers un état fermé après ladite au moins une oscillation permet de transmettre les oscillations suivantes du signal analogique d'entrée au deuxième port du circuit intégré.

Ainsi, l'unité auxiliaire de contrôle permet de supprimer du signal d'entrée la ou les premières oscillations de façon à délivrer dans le signal de sortie des oscillations du signal d'entrée ayant une amplitude inférieure à un seuil.

Dans un mode de réalisation avantageux, la cellule d'entrée/sortie comprend en outre un convertisseur, ou circuit de mise en forme, configuré pour convertir le signal analogique oscillant en un signal carré et pour délivrer ce signal carré à ladite unité auxiliaire de contrôle.

Dans un mode de réalisation avantageux, le convertisseur comprend une bascule de Schmitt.

Dans un mode de réalisation avantageux, l'unité auxiliaire de contrôle comprend un compteur configuré pour compter un nombre défini de fronts du signal carré à partir d'un premier front du signal carré, l'unité auxiliaire de contrôle étant configurée pour permettre un basculement de l'interrupteur vers un état fermé lorsque le compteur atteint le nombre défini de fronts montants par l'unité principal de contrôle.

Ainsi, le compteur permet de compter le nombre d'oscillations ne devant pas être transmises en sortie de la cellule d'entrée/sortie.

En variante, il est possible de prévoir un circuit de temporisation à la place d'un compteur pour déterminer le moment où basculer l'interrupteur vers un état fermé pour transmettre les oscillations au deuxième port de la cellule d'entrée/sortie.

Dans un mode de réalisation avantageux, le circuit intégré comprend en outre ladite unité de traitement reliée au deuxième port du circuit intégré et configurée pour compter le nombre d'oscillations du signal de sortie ayant une amplitude supérieure à un deuxième seuil inférieur au premier seuil.

Selon un autre aspect, il est proposé un système comprenant :
- un capteur inductif capacitif,
- un circuit intégré tel que décrit précédemment dont le premier port est connecté au capteur inductif capacitif,
le capteur inductif capacitif étant adapté pour délivrer ledit signal analogique oscillant après une phase d'excitation déclenchée par le circuit intégré.

Selon un autre aspect il est proposé un débitmètre comprenant un système tel que décrit précédemment.

Selon un autre aspect, il est proposé un procédé de conditionnement d'un signal analogique oscillant comprenant une succession d'oscillations amorties, procédé dans lequel on supprime au moins la première oscillation du signal analogique oscillant et on délivre dans un signal analogique de sortie les autres oscillations du signal analogique oscillant ayant une amplitude inférieure à un premier seuil.

D'autres avantages et caractéristiques de l'invention apparaîtront à l'examen de la description détaillée de modes de mise en œuvre et de réalisation, nullement limitatifs, et des dessins annexés sur lesquels :
[Fig. 1],
[Fig. 2],
[Fig. 3],

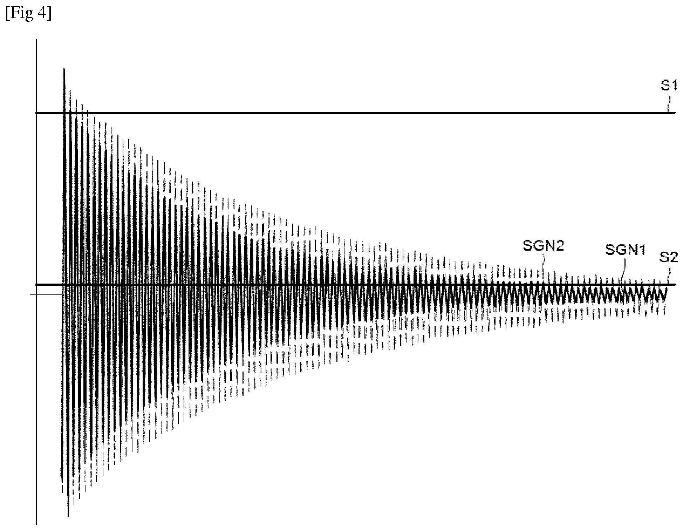

[Fig. 4] illustrent schématiquement des modes de réalisation et de mises en œuvre de l'invention.

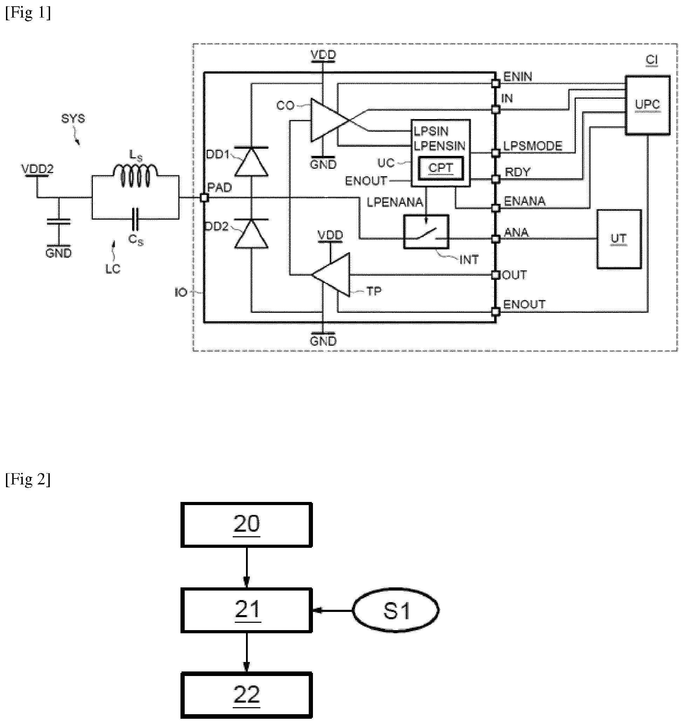

La figure 1 représente un système SYS selon un mode de réalisation de l'invention. Le système comprend un capteur inductif capacitif, dit capteur LC, et un circuit intégré CI comportant une cellule d'entrée/sortie IO, une unité principale de contrôle UPC et une unité de traitement UT.

L'unité de traitement UT est configurée pour tolérer un seuil maximum de tension. Par exemple, l'unité de traitement UT peut être configurée pour traiter des signaux présentant une amplitude maximale de tension de 5V.

Le capteur LC comprend une inductance Ls et une capacité Cs montées en parallèle.

La cellule d'entrée/sortie IO comprend un premier port PAD auquel est connecté le capteur LC.

La cellule d'entrée/sortie IO comprend une première diode DD1 de protection présentant une entrée reliée au premier port PAD et une sortie reliée à une borne d'alimentation destinée à recevoir une tension d'alimentation VDD. La cellule d'entrée/sortie IO comprend également une deuxième diode DD2 de protection présentant une entrée reliée à la masse GND et une sortie reliée au premier port PAD.

La cellule d'entrée/sortie comprend en outre un deuxième port ANA auquel est connectée l'unité de traitement UT.

La cellule d'entrée/sortie IO, qui est une cellule bidirectionnelle, comprend également une entrée ENIN, une sortie IN (bien qu'étant une sortie, celle-ci est désignée par la référence IN eu égard à son placement par rapport à l'unité principale de contrôle UPC), une sortie RDY, une entrée LPSMODE, une entrée ENANA, une entrée ENOUT et une entrée OUT (bien qu'étant une entrée, celle-ci est désignée par la référence OUT eu égard à son placement par rapport à l'unité principale de contrôle UPC).

La cellule d'entrée/sortie IO comprend en outre un interrupteur INT présentant une première borne reliée au premier port PAD et une seconde borne reliée au deuxième port ANA.

L'interrupteur INT peut être commandé dans un état fermé connectant électriquement le premier port PAD au deuxième port ANA. L'interrupteur INT peut également être commandé dans un état ouvert déconnectant le premier port PAD du deuxième port ANA. En particulier, le signal délivré par l'unité principale de contrôle UPC à l'entrée ENANA permet de commander l'interrupteur INT.

L'interrupteur INT peut par exemple être un transistor ou un thyristor. En particulier, l'interrupteur INT est configuré pour tolérer un signal présentant une amplitude supérieure au seuil maximum de tension tolérée par l'unité de traitement. Par exemple, l'interrupteur INT est tolérant aux tensions supérieures à 5V.

La cellule d'entrée/sortie IO comprend également un convertisseur, ou circuit de mise en forme, CO, un circuit tampon TP et une unité auxiliaire de contrôle UC configurée pour commander l'interrupteur INT.

Le convertisseur CO présente une entrée reliée électriquement au premier port PAD et une sortie reliée à une entrée LPSIN de l'unité auxiliaire de contrôle UC. Ce convertisseur CO est alimenté par la tension VDD. Le convertisseur CO présente également un port connecté à la masse. Le convertisseur CO est adapté pour générer en sortie un signal carré à partir d'un signal analogique oscillant en entrée. De préférence, le convertisseur CO est une bascule de Schmitt.

L'unité principale de contrôle UPC est configurée pour délivrer un signal à l'entrée ENIN permettant d'activer ou désactiver le convertisseur CO.

Le signal carré en sortie du convertisseur CO peut être transmis à la sortie IN de façon à pouvoir être traité par l'unité principale de contrôle UPC.

Le convertisseur CO présente deux fonctions. Une première fonction classique consiste à mettre en forme un signal carré distordu (ou bruité) provenant de l'extérieur du circuit intégré, le signal mis en forme est alors transmis à la sortie IN de la cellule d'entrée/sortie. Une deuxième fonction consiste à transformer en signal carré un signal oscillant fourni par le capteur LC. Cette deuxième fonction sera détaillée dans la suite.

Le signal délivré à l'entrée LPSMODE permet d'activer l'unité auxiliaire de contrôle UC.

L'unité auxiliaire de contrôle UC comprend un compteur CPT adapté pour compter un nombre de fronts montants du signal carré délivré par le convertisseur CO à l'entrée LPSIN de l'unité auxiliaire de contrôle UC.

L'unité auxiliaire de contrôle UC est configurée pour recevoir le signal délivré par l'unité principale de contrôle UPC à l'entrée ENANA de la cellule d'entrée/sortie.

Plus particulièrement, l'unité auxiliaire de contrôle UC est configurée pour autoriser la commande de l'interrupteur INT par le signal ENANA ou pour maintenir l'interrupteur INT dans un état ouvert en délivrant un signal de commande LPENANA.

En particulier, l'unité auxiliaire de contrôle UC est configurée pour délivrer un signal de commande LPENANA lorsque le compteur CPT n'a pas encore atteint un nombre n prédéterminé.

L'unité auxiliaire de contrôle UC comprend en outre une entrée configurée pour recevoir un signal reçu par l'entrée ENOUT. Ce signal peut être émis par l'unité principale de contrôle UPC pour activer ou désactiver le circuit tampon TP.

L'unité auxiliaire de contrôle UC comprend également une sortie reliée à la sortie RDY de la cellule d'entrée/sortie IO. L'unité auxiliaire de contrôle UC est ainsi configurée pour émettre un signal à l'unité principale de contrôle UPC lorsque le compteur a atteint le nombre n prédéterminé. L'unité auxiliaire de contrôle UC indique ainsi que l'unité principale de contrôle peut commander l'interrupteur par le signal LPENANA.

Le circuit tampon TP présente une entrée configurée pour recevoir un signal délivré à l'entrée OUT de la cellule d'entrée/sortie IO par l'unité principal de contrôle UPC, une sortie configurée pour délivrer un signal au premier port PAD de la cellule d'entrée/sortie IO.

Le circuit tampon TP comprend également une entrée configurée pour recevoir le signal délivré par l'unité principale de contrôle par l'entrée ENOUT de la cellule d'entrée/sortie IO. Ce signal permet d'activer ou de désactiver le circuit tampon.

Le circuit tampon TP est alimenté par la tension VDD. Le circuit tampon TP présente également un port connecté à la masse GND.

Le circuit tampon TP est configuré pour permettre le déclenchement d'une phase d'excitation du capteur LC. Durant cette phase d'excitation, le premier port PAD est tiré à 0 Volt en mettant le signal ENOUT à 0 pour activer le circuit tampon TP et en mettant l'entrée OUT à 0.

À la fin de la phase d'excitation, le signal ENOUT est mis à 1 pour désactiver le circuit tampon TP. Le premier port PAD n'est alors pas tiré à 0 ou à 1 par le circuit tampon TP. Le capteur LC délivre alors un signal analogique comprenant une succession d'oscillations amorties.

La figure 2 représente un mode de mise en œuvre d'un procédé de conditionnement selon l'invention.

À l'étape 20, le signal électrique oscillant délivré par le capteur LC est transmis au premier port PAD de la cellule d'entrée/sortie IO.

Ce signal électrique oscillant, dit signal d'entrée, arrive ensuite en entrée du convertisseur CO. Le convertisseur CO convertit le signal d'entrée oscillant en un signal carré. Ce signal carré est ensuite transmis à l'entrée LPSIN de l'unité auxiliaire de contrôle UC.

À l'étape 21, au moins la première oscillation du signal d'entrée est supprimée de façon à délivrer dans le signal de sortie les autres oscillations du signal d'entrée.

En particulier, le compteur CPT de l'unité auxiliaire de contrôle UC compte les fronts montants du signal carré, qui sont représentatifs des oscillations du signal d'entrée, jusqu'à atteindre un nombre n prédéfini. Pendant ces n oscillations, l'unité auxiliaire de contrôle UC délivre un signal LPENANA permettant de maintenir l'interrupteur INT dans un état ouvert pour empêcher la transmission de ces n oscillations à l'unité de traitement UT. Lorsque le compteur CPT atteint ce nombre n prédéfini, l'unité auxiliaire de contrôle UC délivre un signal RDY à l'unité principale de contrôle de façon à permettre le contrôle de l'interrupteur INT par le signal délivré par l'unité principale de contrôle UPC à l'entrée ENANA. Le signal délivré à l'entrée ENANA peut alors commander l'interrupteur INT dans un état fermé. Les oscillations suivantes du signal analogiques oscillant délivré par le capteur LC sont alors transmises à l'unité de traitement UT à l'étape 22.

En particulier, le nombre n d'oscillations est défini en fonction du seuil S1 maximum de tension pouvant être toléré par l'unité de traitement UT.

Ainsi, l'unité auxiliaire de contrôle UC permet, en contrôlant l'interrupteur INT dans un état ouvert pendant les n premières oscillations, de pouvoir transmettre à l'unité de traitement UT que les oscillations du signal d'entrée présentant une amplitude inférieure au seuil S1.

En particulier, ces n oscillations pourraient présenter une amplitude qui pourrait entraîner une défaillance des composants électronique de l'unité de traitement UT si ces n oscillations étaient transmises à l'unité de traitement UT. Par exemple, ces n oscillations peuvent présenter une amplitude supérieure à 5V alors que l'unité de traitement UT présente un seuil maximum de tension de 5V.

En empêchant la transmission de ces n oscillations à l'unité de traitement UT, l'unité auxiliaire de contrôle UC permet de protéger l'unité de traitement UT contre les oscillations ayant une amplitude pouvant entraîner une défaillance de l'unité de traitement UT.

En particulier, l'unité auxiliaire de contrôle UC peut par exemple être configurée pour supprimer uniquement la première oscillation, ou bien les deux premières oscillations ou encore les trois premières oscillations du signal d'entrée. En d'autres termes n peut être égal à 1, 2 ou 3 par exemple.

La cellule d'entrée/sortie IO peut être fabriquée à partir d'une cellule d'entrée/sortie classique dans laquelle l'unité auxiliaire de contrôle UC ainsi que l'entrée LPSMODE et la sortie RDY sont ajoutées.

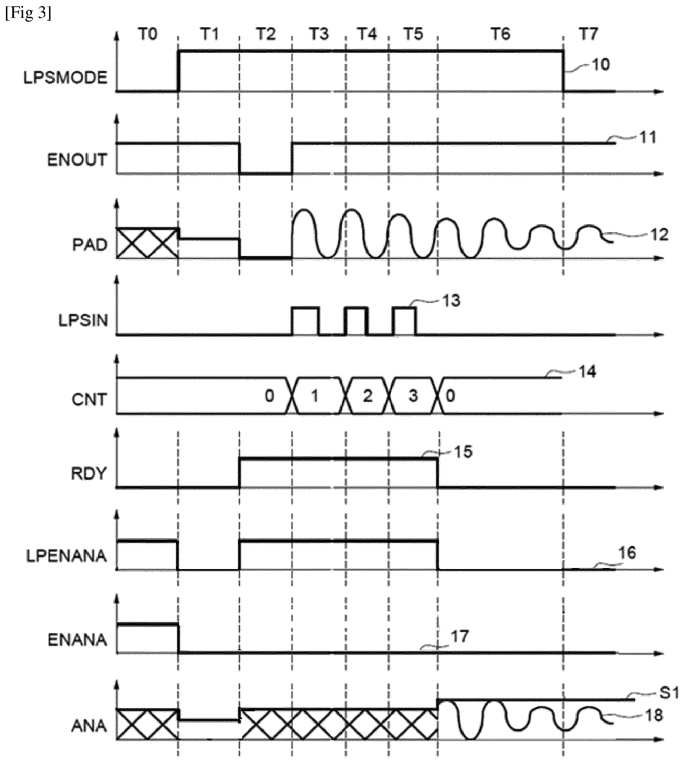

La figure 3 illustre un chronogramme représentant une mise en œuvre d'un procédé selon un mode de réalisation de l'invention.

La courbe 10 représente le signal délivré à l'entrée LPSMODE.

La courbe 11 représente le signal délivré à l'entrée ENOUT.

La courbe 12 représente le signal délivré par le capteur LC sur le premier port PAD.

La courbe 13 représente le signal délivré à l'entrée LPSIN de l'unité auxiliaire de contrôle UC.

La courbe 14 représente la valeur du compteur CPT de l'unité auxiliaire de contrôle UC.

La courbe 15 représente le signal délivré à l'entrée RDY.

La courbe 16 représente le signal LPENANA délivré par l'unité auxiliaire de contrôle UC.

La courbe 17 représente le signal délivré à l'entrée ENANA.

La courbe 18 représente le signal délivré par la sortie ANA.

Dans cette mise en œuvre du procédé, l'unité auxiliaire de contrôle UC est configurée pour permettre un basculement de l'interrupteur INT dans un état fermé après trois oscillations du signal analogique oscillant délivré par le capteur LC (*n* est donc prédéfini à 3).

En outre, dans cette mise en œuvre, les signaux délivrés aux entrées ENIN, ENANA et ENOUT ainsi que le signal LPENANA sont des signaux de commande actifs à l'état bas, ici à 0.

À l'étape T0, le signal délivré à l'entrée LPSMODE est à 0. L'unité auxiliaire de contrôle UC est alors désactivée. Le signal ENOUT, le signal LPENANA et le signal ENANA sont à 1 de sorte que l'unité auxiliaire de contrôle UC est désactivée et l'interrupteur INT est dans un état ouvert. Le signal RDY est à 0. Le capteur LC ne délivre aucun signal. En outre, le signal ENIN (non représenté) est à 0 de façon à activer le convertisseur CO.

À l'étape T1, le signal délivré à l'entrée LPSMODE est mis à 1. L'unité auxiliaire de contrôle UC est activée. La tension au premier port PAD de la cellule d'entrée/sortie IO est tirée à Vmid où Vmid = VDD/2. En particulier, la tension Vmid est imposée par un circuit non représenté à la figure 1.

À l'étape T2, le signal délivré à l'entrée ENOUT est mis à 0 pour activer le circuit tampon TP. Le signal d'entrée OUT (non représenté) est à 0. La tension au premier port PAD de la cellule d'entrée/sortie IO est tirée à 0 V. Cette phase correspond à la phase d'excitation de capteur LC. L'unité auxiliaire de contrôle UC met le signal LPENANA à 1 de façon à forcer l'interrupteur dans un état ouvert. L'interrupteur INT ne peut plus être contrôlé par le signal ENANA. Le signal délivré à l'entrée RDY passe à 1 pour indiquer à l'unité principal de contrôle UPC que l'interrupteur est ouvert et qu'il n'est pas contrôlable par le signal ENANA.

À l'étape T3, le signal ENOUT est mis à 1 marquant la fin de la phase d'excitation. Le capteur LC délivre alors le signal analogique oscillant d'entrée sur le premier port PAD, le signal analogique comprenant une succession d'oscillations amorties. Une première oscillation est convertie en un signal carré LPSIN par le convertisseur CO. Le compteur CPT compte un premier front montant sur le signal LPSIN. L'interrupteur INT est forcé dans un état ouvert par le signal LPENANA qui est maintenu à 1, le signal ENANA est ignoré. Ainsi, cette première oscillation n'est pas transmise à la sortie ANA de la cellule d'entrée/sortie.

À l'étape T4, un deuxième front montant sur le signal LPSIN est compté par le compteur CPT. L'interrupteur INT est maintenu dans un état ouvert par le signal LPENANA qui est à 1. La deuxième oscillation n'est pas transmise à la sortie ANA de la cellule d'entrée/sortie.

À l'étape T5, un troisième front montant sur le signal LPSIN est compté par le compteur CPT. Le compteur CPT atteint alors le nombre n prédéfini d'oscillations à ne pas transmettre à l'unité de traitement UT. Il est alors assuré que les oscillations suivantes présenteront une amplitude inférieure au seuil S1. L'interrupteur INT est maintenu dans un état ouvert par le signal LPENANA. La troisième oscillation n'est pas transmise à la sortie ANA de la cellule d'entrée/sortie.

À l'étape T6, le signal LPENANA passe à 0. L'interrupteur INT n'est alors plus forcé dans un état ouvert par le signal LPENANA et redevient contrôlable par le signal délivré à l'entrée ENANA. Le signal délivré à l'entrée ENANA étant à 0, l'interrupteur bascule dans un état fermé. L'unité auxiliaire de contrôle passe à 0 le signal délivré à la sortie RDY pour indiquer à l'unité principale de contrôle que l'interrupteur peut être commandé par le signal ENANA.

L'interrupteur INT étant dans un état fermé, les oscillations suivantes du signal d'entrée sont transmises à l'unité de traitement UT. Le compteur CPT est remis à 0. Le signal RDY est mis à 0.

À l'étape T7, le signal LPSMODE est mis à 0.

Le système SYS décrit précédemment peut être utilisé dans un débitmètre. En particulier, dans un tel débitmètre, le capteur LC est utilisé en combinaison d'une roue présentant au moins une portion conductrice et au moins une portion non conductrice. La roue est placée dans un écoulement de fluide de façon à pouvoir être entraînée en rotation par ce dernier. Le capteur LC est quant à lui fixe. Le capteur LC génère des signaux analogiques oscillants. Ces signaux analogiques oscillants sont plus ou moins amortis en fonction de la position relative du capteur LC par rapport à la portion conductrice.

À titre illustratif, la figure 4 montre deux signaux analogiques oscillants SGN1, SGN2 pouvant être générés par le capteur LC. Un premier signal SGN1 est obtenu lorsque le capteur LC est proche d'une portion conductrice de la roue. Le deuxième signal SGN2 est obtenu lorsque le capteur LC est proche d'une portion non conductrice de la roue. On peut ainsi observer que le premier signal SGN1 est plus amorti que le deuxième signal SGN2.

L'unité de traitement UT est configurée pour déterminer un débit de fluide à partir de la vitesse de rotation de la roue. La vitesse de rotation de la roue est déterminée en analysant l'amortissement des signaux analogiques oscillants générés par le capteur LC.

En particulier, la position relative de la roue par rapport au capteur LC est déterminée en comptant le nombre d'oscillations du signal de sortie transmis à l'unité de traitement UT et qui présentent une amplitude supérieure à un seuil S2. La détermination de la position relative du capteur LC par rapport à la portion conductrice de la roue à différent instant permet de déduire la vitesse de rotation de la roue et donc le débit de fluide.

L'unité de traitement UT compte ainsi les oscillations du signal généré par le capteur LC présentant une amplitude comprise entre le seuil S1 et le seuil S2, les oscillations présentant une amplitude supérieure à S1 ayant été supprimée par la cellule d'entrée/sortie IO.

Il est à noter que la suppression de la ou les premières oscillations du signal d'entrée n'a qu'un effet négligeable sur la détermination du débit de fluide. En effet, il y a généralement une centaine d'oscillations prises en compte pour la détermination du débit.

Le fonctionnement général d'un tel débitmètre est bien connu de l'homme du métier et est notamment décrit dans la note AN4636 intitulée « Demonstration of LC sensor for gas or water metering based on STM32L073Z-EVAL and STM32L476RG-NUCLEO boards » publiée en septembre 2017 par la société STMicroelectronics et disponible sur le site internet : https://www.st.com/content/ccc/resource/technical/document/applicati on_note/18/14/02/2d/dd/8f/4c/93/DM00151831.pdf/files/DM00151831. pdf/jcr:content/translations/en.DM00151831.pdf.

Bien entendu, la présente invention est susceptible de diverses variantes et modifications qui apparaîtront à l'homme de l'art. Par exemple, en variante du compteur CPT de l'unité auxiliaire de contrôle UC, il est possible de prévoir un circuit de temporisation permettant de supprimer du signal d'entrée, au moins la première oscillation de façon à délivrer dans le signal de sortie des oscillations du signal d'entrée ayant une amplitude inférieure à un seuil.

En outre, il est avantageux de doubler ledit convertisseur CO. On utilise alors deux convertisseurs en parallèle. En doublant le convertisseur CO, il est possible d'augmenter l'hystérésis de façon à immuniser le signal délivré en entrée de l'unité auxiliaire de contrôle UC des bruits sur l'alimentation de chaque convertisseur CO.

## Revendications

1. Circuit intégré de conditionnement d'un signal analogique oscillant comprenant une succession d'oscillations amorties, le circuit intégré comprenant une cellule d'entrée/sortie (IO) comportant :
- un premier port (PAD) configuré pour recevoir ledit signal analogique oscillant, dit signal d'entrée,
- un deuxième port (ANA) configuré pour délivrer un signal analogique de sortie à partir du signal d'entrée,
**caractérisé par**
- des moyens de contrôle comportant un interrupteur connecté entre le premier port et le deuxième port, et configurés pour supprimer du signal d'entrée au moins la première oscillation de façon à délivrer dans le signal de sortie des oscillations du signal d'entrée ayant une amplitude inférieure à un premier seuil.

2. Circuit intégré selon la revendication 1 comprenant en outre une unité de traitement (UT) connectée au deuxième port, le premier seuil étant compatible avec un niveau maximum de tension tolérable par l'unité de traitement.

3. Circuit intégré selon l'une quelconque des revendications 1 ou 2, comprenant en outre une unité principale de contrôle (UPC) et dans lequel les moyens de contrôle comportent :
- l'interrupteur commandable par l'unité principale de contrôle (UPC),
- une unité auxiliaire de contrôle (UC) configurée pour prendre temporairement le contrôle de l'interrupteur (INT) à la place de l'unité principale de contrôle (UPC) de façon à permettre ladite suppression de ladite au moins la première oscillation du signal d'entrée.

4. Circuit intégré selon la revendication 3 dans lequel:
- l'interrupteur (INT) est configuré pour fonctionner en présence d'une ou de plusieurs oscillations du signal d'entrée ayant une amplitude supérieure ou égale audit premier seuil, et ayant une première borne reliée au premier port (PAD) et une seconde borne reliée au deuxième port (ANA), l'interrupteur pouvant être commandé :
∘ soit dans un état fermé connectant électriquement le premier port (PAD) au deuxième port (ANA),
∘ soit dans un état ouvert déconnectant le premier port (PAD) du deuxième port (ANA), et
- l'unité auxiliaire de contrôle (UC) est configurée pour :
∘ maintenir l'interrupteur (INT) dans un état ouvert pendant la première oscillation du signal d'entrée et éventuellement une ou plusieurs oscillations succédant directement à la première oscillation, puis
∘ permettre un basculement de l'interrupteur (INT) vers un état fermé.

5. Circuit intégré selon l'une quelconque des revendications 3 ou 4 dans lequel la cellule d'entrée/sortie comprend en outre un convertisseur (CO) configuré pour convertir le signal analogique oscillant en un signal carré et pour délivrer ce signal carré à ladite unité auxiliaire de contrôle (UC).

6. Circuit intégré selon la revendication 5 dans lequel le convertisseur (CO) comprend une bascule de Schmitt.

7. Circuit intégré selon l'une quelconque des revendications 3 à 6, dans lequel l'unité auxiliaire de contrôle (UC) comprend un compteur (CPT) configuré pour compter un nombre défini de fronts du signal carré à partir d'un premier front du signal carré, l'unité auxiliaire de contrôle (UC) étant configurée pour permettre un basculement de l'interrupteur (INT) vers un état fermé lorsque le compteur (CPT) atteint le nombre défini de fronts montants.

8. Circuit intégré selon l'une des revendications 2 à 7 prise en combinaison avec la revendication 2, dans lequel l'unité de traitement (UT) reliée au deuxième port du circuit intégré (ANA) est configurée pour compter le nombre d'oscillations du signal de sortie ayant une amplitude supérieure à un deuxième seuil inférieur au premier seuil.

9. Système comprenant :
- un capteur inductif capacitif (LC),
- un circuit intégré (CI) selon l'une des revendications 1 à 8 dont le premier port est connecté au capteur inductif capacitif,
le capteur inductif capacitif (LC) étant adapté pour délivrer ledit signal analogique oscillant après une phase d'excitation déclenchée par le circuit intégré (CI).

10. Débitmètre comprenant un système selon la revendication 9.

11. Procédé de conditionnement d'un signal analogique oscillant comprenant une succession d'oscillations amorties, procédé dans lequel on supprime (21) au moins la première oscillation du signal analogique oscillant, par la commande d'un interrupteur, et on délivre dans un signal analogique de sortie les autres oscillations du signal analogique oscillant ayant une amplitude inférieure à un premier seuil.

## Patentansprüche

1. Integrierte Schaltung zur Konditionierung eines schwingenden analogen Signals, das eine Abfolge von gedämpften Schwingungen umfasst, wobei die integrierte Schaltung eine Eingangs-/Ausgangszelle (IO) umfasst, die Folgendes umfasst:
- einen ersten Anschluss (PAD), der so konfiguriert ist, dass er das schwingende analoge Signal, das sogenannte Eingangssignal, empfängt,
- einen zweiten Anschluss (ANA), der so konfiguriert ist, dass er ein analoges Ausgangssignal aus dem Eingangssignal ausgibt, **gekennzeichnet durch**
- Steuerungsmittel, die einen Schalter aufweisen, der zwischen dem ersten Anschluss und dem zweiten Anschluss angeschlossen ist, und die so konfiguriert sind, dass sie mindestens die erste Schwingung vom Eingangssignal unterdrücken, um im Ausgangssignal Schwingungen des Eingangssignals, die eine Amplitude unter einem ersten Schwellenwert aufweisen, auszugeben.

2. Integrierte Schaltung nach Anspruch 1, ferner umfassend eine Verarbeitungseinheit (UT), die an den zweiten Anschluss angeschlossen ist, wobei der erste Schwellenwert mit einem von der Verarbeitungseinheit tolerierbaren maximalen Spannungspegel kompatibel ist.

3. Integrierte Schaltung nach einem der Ansprüche 1 oder 2, ferner umfassend eine Hauptsteuerungseinheit (UPC) und bei der die Steuerungsmittel Folgendes aufweisen:
- den von der Hauptsteuerungseinheit (UPC) steuerbaren Schalter,
- eine Hilfssteuerungseinheit (UC), die so konfiguriert ist, dass sie vorübergehend die Steuerung des Schalters (INT) anstelle der Hauptsteuerungseinheit (UPC) übernimmt, um das Unterdrücken der mindestens ersten Schwingung des Eingangssignals zu ermöglichen.

4. Integrierte Schaltung nach Anspruch 3, wobei:
- der Schalter (INT) so konfiguriert ist, dass er bei Vorhandensein einer oder mehrerer Schwingungen des Eingangssignals, die eine Amplitude über oder gleich dem ersten Schwellenwert aufweisen, arbeitet und eine erste Klemme hat, die mit dem ersten Anschluss (PAD) verbunden ist, und eine zweite Klemme, die mit dem zweiten Anschluss (ANA) verbunden ist, wobei der Schalter gesteuert werden kann:
∘ entweder in einem geschlossenen Zustand, der den ersten Anschluss (PAD) elektrisch mit dem zweiten Anschluss (ANA) verbindet,
∘ oder in einem geöffneten Zustand, der den ersten Anschluss (PAD) vom zweiten Anschluss (ANA) trennt, und
- die Hilfssteuerungseinheit (UC) für Folgendes konfiguriert ist:
∘ Halten des Schalters (INT) während der ersten Schwingung des Eingangssignals und eventuell einer oder mehrerer Schwingungen, die direkt auf die erste Schwingung folgen, in einem geöffneten Zustand, dann
∘ Ermöglichen des Umschaltens des Schalters (INT) in einen geschlossenen Zustand.

5. Integrierte Schaltung nach einem der Ansprüche 3 oder 4, wobei die Eingangs-/Ausgangszelle ferner einen Wandler (CO) umfasst, der so konfiguriert ist, dass er das schwingende analoge Signal in ein Rechtecksignal umwandelt und dieses Rechtecksignal an die Hilfssteuerungseinheit (UC) ausgibt.

6. Integrierte Schaltung nach Anspruch 5, wobei der Wandler (CO) einen Schmitt-Trigger umfasst.

7. Integrierte Schaltung nach einem der Ansprüche 3 bis 6, wobei die Hilfssteuerungseinheit (UC) einen Zähler (CPT) umfasst, der so konfiguriert ist, dass er eine definierte Anzahl von Flanken des Rechtecksignals ab einer ersten Flanke des Rechtecksignals zählt, wobei die Hilfssteuerungseinheit (UC) so konfiguriert ist, dass sie ein Umschalten des Schalters (INT) in einen geschlossenen Zustand ermöglicht, wenn der Zähler (CPT) die definierte Anzahl von steigenden Flanken erreicht.

8. Integrierte Schaltung nach einem der Ansprüche 2 bis 7 in Kombination mit Anspruch 2, wobei die mit dem zweiten Anschluss der integrierten Schaltung (ANA) verbundene Verarbeitungseinheit (UT) so konfiguriert ist, dass sie die Anzahl der Schwingungen des Ausgangssignals zählt, die eine Amplitude über einem zweiten Schwellenwert aufweisen, der unter dem ersten Schwellenwert liegt.

9. System, umfassend:
- einen induktiv-kapazitiven Sensor (LC),
- eine integrierte Schaltung (IC) nach einem der Ansprüche 1 bis 8, deren erster Anschluss an den kapazitiven Induktivsensor angeschlossen ist,
wobei der kapazitive Induktivsensor (LC) dazu geeignet ist, das schwingende analoge Signal nach einer von der integrierten Schaltung (IC) ausgelösten Erregerphase auszugeben.

10. Durchflussmesser, umfassend ein System nach Anspruch 9.

11. Verfahren zur Konditionierung eines schwingenden analogen Signals, das eine Abfolge von gedämpften Schwingungen umfasst, wobei mindestens die erste Schwingung des schwingenden analogen Signals durch die Ansteuerung eines Schalters unterdrückt (21) wird und die anderen Schwingungen des schwingenden analogen Signals, die eine Amplitude unter einem ersten Schwellenwert aufweisen, in einem analogen Ausgangssignal ausgegeben werden.

## Claims

1. An integrated circuit for conditioning an analogue oscillating signal comprising a succession of damped oscillations, the integrated circuit comprising an input/output (IO) cell including:
- a first port (PAD) configured to receive said oscillating analogue signal, so-called the input signal,
- a second port (ANA) configured to deliver an analogue output signal from the input signal, **characterised by**
- control means including a switch connected between the first port and the second port, and configured to remove at least the first oscillation from the input signal so as to produce, in the output signal, oscillations of the input signal having an amplitude below a first threshold.

2. The integrated circuit according to claim 1, further comprising a processing unit (UT) connected to the second port, the first threshold being compatible with a maximum voltage level that the processing unit can tolerate.

3. The integrated circuit according to any one of claims 1 or 2, further comprising a main control unit (UPC) and wherein the control means include:
- the switch controllable by the main control unit (UPC),
- an auxiliary control unit (UC) configured to temporarily take control of the switch (INT) in place of the main control unit (UPC) so as to enable said suppression of at least the first oscillation from the input signal.

4. The integrated circuit according to claim 3, wherein
- the switch (INT) is configured to operate in the presence of one or more oscillations of the input signal having an amplitude greater than or equal to said first threshold, and having a first terminal connected to the first port (PAD) and a second terminal connected to the second port (ANA), the switch being controllable:
∘ either in a closed state electrically connecting the first port (PAD) to the second port (ANA),
∘ or in an open state disconnecting the first port (PAD) from the second port (ANA), and
- the auxiliary control unit (UC) is configured to:
o hold the switch (INT) in an open state during the first oscillation of the input signal and possibly one or more oscillations directly succeeding the first oscillation, and then
o allow the switch (INT) to be switched to a closed state.

5. The integrated circuit according to any one of claims 3 or 4, wherein the input/output cell further comprises a converter (CO) configured to convert the oscillating analogue signal into a square-wave signal and to deliver this square-wave signal to said auxiliary control unit (UC).

6. The integrated circuit according to claim 5, wherein the converter (CO) comprises a Schmitt trigger.

7. The integrated circuit according to any one of claims 3 to 6, wherein the auxiliary control unit (UC) comprises a counter (CPT) configured to count a defined number of edges of the square-wave signal from a first edge of the square-wave signal, the auxiliary control unit (UC) being configured to enable the switch (INT) to be switched to a closed state when the counter (CPT) reaches the defined number of rising edges.

8. The integrated circuit according to one of claims 2 to 7 taken in combination with claim 2, wherein the processing unit (UT) connected to the second port of the integrated circuit (ANA) is configured to count the number of oscillations of the output signal having an amplitude greater than a second threshold lower than the first threshold.

9. A system comprising:
- an inductive capacitive sensor (LC),
- an integrated circuit (IC) according to any one of claims 1 to 8, the first port of which is connected to the inductive capacitive sensor,
the inductive capacitive sensor (LC) being adapted to deliver said oscillating analogue signal after an excitation phase triggered by the integrated circuit (IC).

10. A flowmeter comprising a system according to claim 9.

11. A method for conditioning an oscillating analogue signal comprising a succession of damped oscillations, in which method at least the first oscillation of the oscillating analogue signal is suppressed (21), by controlling a switch, and the other oscillations of the analogue oscillating signal having an amplitude below a first threshold are output in an analogue signal.
